# EUROPÄISCHE PATENTANMELDUNG

(11) **EP 1 568 733 A1**
(43) Veröffentlichungstag der Anmeldung: **31.08.2005**
(21) Anmeldenummer: 04405096.1
(22) Anmeldetag: 20.02.2004
(51) Int. Cl.: C08K 9/06, H01L 23/29, H01B 3/30, C08L 63/00

(54) **Füllstoff bestehend aus mit Organopolysiloxan beschichteten porösen anorganischen Füllstoffteilchen zur Verwendung in härtbaren Vergussmassen**

(71) Anmelder: ABB RESEARCH LTD., 8050 Zürich (CH)
(72) Erfinder: Meier, Patrick, 5600 Lenzburg (CH); Rocks, Jens, 8057 Zürich (CH)
(74) Vertreter: ABB Patent Attorneys

(57) **Zusammenfassung**

Füllstoff, welcher für die Verwendung in elektrischen Formteilen und elektrischen Beschichtungen auf Basis einer Duroplastmatrix oder einer thermoplastischen Vergussmasse geeignet ist, wobei der Füllstoff aus porösen anorganischen Pulverteilchen besteht, deren Porenoberfläche mit einem linearen, zweidimensionalen, dreidimensionalen und/oder cyclischen Organopolysiloxan oder einem Gemisch solcher Organopolysiloxane beschichtet ist; Verwendung des Füllstoffs in duroplastisch härtbaren Vergussmassen oder thermoplastischen Vergussmassen sowie die daraus hergestellten Bauteile.

## Beschreibung

Die vorliegende Erfindung betrifft einen Füllstoff für die Verwendung in duroplastisch härtbaren und/oder thermoplastischen Vergussmassen bzw. in duroplastisch härtbaren und/oder thermoplastischen Kunststoffen. Insbesondere betrifft die vorliegende Erfindung einen Füllstoff bestehend aus porösen anorganischen Pulverteilchen, deren Porenoberfläche mit einem Organopolysiloxan oder einem Gemisch von Organopolysiloxanen beschichtet ist. Der erfindungsgemässe Füllstoff ist insbesondere für die Verwendung in duroplastisch härtbaren Vergussmassen geeignet, wobei solche Vergussmassen vorzugsweise für die Herstellung von elektrischen Formteilen und elektrischen Beschichtungen verwendet werden. In diesem Sinne betrifft die vorliegende Erfindung auch die duroplastisch härtbaren Vergussmassen, welche einen erfindungsgemässen Füllstoff enthalten sowie die daraus hergestellten elektrischen Formteile und Beschichtungen.

### Technisches Gebiet

Elektrische Formteile und Beschichtungen auf Basis duroplastisch härtbarer Epoxidharze sind an sich bekannt. Für Freiluftanwendungen werden aber vorzugsweise Isolatoren auf Basis von Glas und Keramik eingesetzt. Dabei kommen Freiluftisolatoren in grossen Stückzahlen bei Hochspannungsleitungen, beispielsweise als Hochspannungsisolierungen, als auch im Mittelspannungsbereich, beispielsweise als Stützisolatoren, zum Einsatz. Weitere Anwendungsgebiete sind Freiluft-Leistungsschalter, Messwandler, Durchführungen, Ableiter sowie im Schaltanlagenbau.

Ebenso sind mit Füllstoff befüllte elektrische Isolatoren auf der Basis von Duroplasten, z.B. solche auf der Basis von Epoxidharzen, an sich bekannt und werden in der Elektrotechnik in den genannten Anwendungsgebieten, insbesondere als strukturelle Feststoffisolationen bei Mittel- und Hochspannungsanlagen, sowie auch als Generatorschalter oder in gasisolierten Schaltanlagen, eingesetzt.

Giessharzsysteme auf Basis von duroplastisch härtbaren organischen Harzen, wie beispielsweise Epoxidharze, besitzen in der Regel keine intrinsische Hydrophobiewiederkehr und weisen zudem eine vergleichsweise niedrigere Hydrophobie auf. Es besteht deshalb das Bedürfnis diese Giessharzsysteme so zu verbessern, dass diese für die Herstellung von elektrischen Isolierungen geeignet sind, das heisst eine erhöhte Hydrophobie sowie gleichzeitig auch die Eigenschaft der Hydrophobiewiederkehr aufweisen, ohne dass die guten mechanischen Eigenschaften merklich verändert bzw. geschwächt werden. Derart könnten preisgünstige Epoxidharze für die Herstellung von elektrischen Formteilen und Beschichtungen, wie beispielsweise selbst heilende elektrische Isolierungen, auch auf dem Gebiet der Hochspannungsisolierungen für den Freilufteinsatz verwendet werden.

### Stand der Technik

In EP 0 899 304 wird beispielsweise vorgeschlagen, die guten elektrischen Eigenschaften von Silikonen, wie z.B. von Dimethylsiloxanen, mit den Eigenschaften von Epoxidharzen zu verbinden und der Vergussmassen eine reaktive Silikonverbindung zuzusetzen. Siloxanverbindungen und Epoxidverbindungen sind in der Regel nicht genügend mit einander mischbar, so dass Stabilisatoren wie oberflächenaktive Mittel oder Mittel, welche die Viskosität des Systems erhöhen, beigemischt werden müssen. Die Stabilisatoren stabilisieren zwar die zweiphase Morphologie des Systems, sie senken aber dessen Glasübergangstemperatur und verschlechtern dessen mechanischen Eigenschaften.

### Darstellung der Erfindung

Es wurde nun gefunden, dass elektrische Formteile und Isolatoren, welche aus einer Duroplastmatrix, vorzugsweise aus einer Epoxidharzmatrix, bestehen, eine überraschend erhöhte Hydrophobie sowie gleichzeitig auch die Eigenschaft der Hydrophobiewiederkehr über einen verlängerten Zeitraum, in der Regel für die gesamte Lebensdauer der Isolatoren, aufweisen, ohne dass die guten mechanischen Eigenschaften merklich verändert bzw. geschwächt werden, wenn man der Vergussmasse vor der Härtung einen Füllstoff bestehend aus porösen anorganischen Pulverteilchen, deren Porenoberfläche mit einem Organopolysiloxan oder einem Gemisch von Organopolysiloxanen beschichtet ist, zusetzt. Solche Pulverteilchen unterscheiden sich deutlich in ihrer Wirkung von vergleichsweise kompakten Pulverteilchen, deren äussere Oberfläche mit einem Silikonharz behandelt wurde.

Die vorliegende Erfindung ist in den Patentansprüchen definiert. Insbesondere betrifft die vorliegende Erfindung einen Füllstoff, welcher für die Verwendung in elektrischen Formteilen und elektrischen Beschichtungen auf Basis einer Duroplastmatrix oder einer thermoplastischen Vergussmasse geeignet ist, dadurch gekennzeichnet, dass der Füllstoff aus porösen anorganischen Pulverteilchen besteht, deren Porenoberfläche mit einem linearen, zweidimensionalen, dreidimensionalen und/oder cyclischen Organopolysiloxan oder einem Gemisch solcher Organopolysiloxane beschichtet ist.

Die Erfindung betrifft auch Verfahren zur Herstellung des erfindungsgemässen Füllstoffs. Die Erfindung betrifft auch duroplastisch härtbare Vergussmassen auf Basis einer Duroplastmatrix oder einer thermoplastischen Vergussmasse, welche den erfindungsgemässen Füllstoff enthalten, sowie die Verwendung solcher duroplastisch härtbaren Vergussmassen für die Herstellung von elektrischen Formteilen und Isolatoren.

Die Erfindung betrifft auch elektrische Formteile und Isolatoren, auf Basis einer Duroplastmatrix oder auf der Basis einer thermoplastischen Vergussmasse, dadurch gekennzeichnet, dass die Duroplastmatrix oder die thermoplastische Vergussmasse dieser Formteile und Isolatoren mindestens einen erfindungsgemässen Füllstoff in einer wirksamen Konzentration bzw. Menge enthalten. Bevorzugt sind jeweils immer duroplastische Vergussmassen.

Der erfindungsgemässe Füllstoff besteht aus porösen anorganischen (mineralischen) Pulverteilchen (oder mehreren agglomerierten Pulverteilchen), deren innere Oberfläche, das ist deren Porenoberfläche, mit einem linearen, zweidimensionalen, dreidimensionalen und/oder cyclischen Organopolysiloxan oder einem Gemisch solcher Organopolysiloxane beschichtet ist. Dabei können die Poren, je nach dem Belegungsgrad der Porenoberfläche, teilweise oder gänzlich durch das Organopolysiloxan verschlossen sein.

Die im erfindungsgemässen Füllstoff enthaltenen anorganischen porösen Pulverteilchen sind erfindungsgemäss an sich bekannte, in der Elektroindustrie verwendete, Füllstoffe, wie beispielsweise Siliziumoxid (Aerosile, Quarz), Aluminiumoxid, Magnesium- und Aluminiumhydroxide, [Mg(OH)₂, Al(OH)₃, AlO(OH)], Gesteinsmehle und natürliche oder synthetische Mineralien hauptsächlich aus der Silikatreihe, wie zum Beispiel Glimmer, Kaolin, Wollastonit, Bentonit, Calciumsilikate, wie Xonolit [Ca₂Si₆O₁₇(OH)₂], Aluminiumsilikate wie Andalusit [Al₂O₃.SiO₂] oder Zeolithe, Calcium/-Magnesiumcarbonate, wie Dolomit [CaMg(CO₃)₂], sowie bekannte Calcium/Magnesiumsilikate, in verschiedenen an sich bekannten Mahlungen. Bevorzugt sind Siliziumoxid und/oder Aluminiumoxid, Xonolit, Magnesium- und Aluminiumhydroxide, Gesteinsmehle und natürliche oder synthetische Mineralien aus der Silikatreihe.

Bevorzugt ist eine Mahlung des erfindungsgemässen Füllstoffs mit einer durchschnittlichen Korngrösse im Bereich von 1 µm bis 300 µm, vorzugsweise von 5 µm bis 100 µm.

Als "poröses Pulver" bzw. "poröse Pulverteilchen" werden hierin Pulver bezeichnet, welche aus anorganischen (noch nicht beschichteten) Pulverteilchen bestehen, die infolge ihrer Porosität eine Dichte im Bereich von 60% bis 80% im Vergleich zur realen Dichte der nicht porösen Pulverteilchen aufweisen.

Im Vergleich zu nicht porösen Pulverteilchen weisen die verwendeten porösen anorganischen Pulverteilchen infolge der zusätzlichen "inneren" Oberfläche eine stark erhöhte Gesamtoberfläche auf. Diese beträgt vorzugsweise mindestens 20 m²/g (BET m²/g) und vorzugsweise 30 m²/g (BET) und liegt vorzugsweise im Bereich von 30m²/g (BET) bis 100 m²/g (BET), vorzugsweise 40 m²/g (BET) bis 60 m²/g (BET).

Vorzugsweise enthält der erfindungsgemässe Füllstoff, das heisst das erfindungsgemäss mit dem Organopolysiloxan behandelte bzw. beschichtete poröse anorganische Pulver, das Organopolysiloxan in einem Volumenanteil von 10-40 Vol.-%, und vorzugsweise in einer Menge von 17-25 Vol.-%, bezogen auf das Gesamtvolumen des beschichteten Füllstoffs (Belegungsgrad). Dabei wird jeweils mindestens die Porenoberfläche beschichtet. Dabei können die Poren offen bleiben oder verschlossen werden. Das allenfalls verbleibende Hohlvolumen ist nicht kritisch.

Vorzugsweise enthält der erfindungsgemässe Füllstoff, das heisst das erfindungsgemäss mit dem Organopolysiloxan beschichtete poröse anorganische Pulver, das Organopolysiloxan im Gewichtsverhältnis von 50-80 Gew.-%, vorzugsweise von 63-71 Gew.-%, bezogen auf das Gesamtgewicht des beschichteten Füllstoffs (Belegungsgrad).

Der erfindungsgemässe Füllstoff wird der Vergussmasse in einer Menge zugesetzt, so dass diese die Polysiloxanverbindung, oder das Gemisch der Polysiloxanverbindungen, in einer Menge von etwa 0.6-30 Gew.-%, vorzugsweise etwa 12-27 Gew.-% und insbesondere in einer Menge von etwa 17-23 Gew.-%, bezogen auf das Gesamtgewicht der Vergussmasse, enthält.

Die für die Beschichtung erfindungsgemäss verwendeten Polyorganosiloxane haben vorzugsweise eine Viskosität im Bereich von etwa 0.97 mPa.s (1 cSt) bis etwa 19'500 mPa.s (gemessen gemäss DIN 53 019 bei 25°C, berechnet mit einer Dichte von 0.97)) und stellen eine lineare, zweidimensional oder dreidimensional verzweigte Verbindung, ein Gemisch oligomerer Verbindungen oder ein Gemisch solcher Verbindungen dar.

Die Viskosität dieser Organopolysiloxane liegt vorzugsweise im Bereich von etwa 0.97 mPa.s (1 cSt) bis etwa 4900 mPa.s, vorzugsweise im Bereich von etwa 2 mPa.s bis 2900 mPa.s, vorzugsweise im Bereich von etwa 5 bis 700 mPa.s, gemessen gemäss DIN 53 019 bei 25°C.

Vorzugsweise haben diese Polysiloxane ein Molekulargewicht im Bereich von etwa 300 bis 100'000, vorzugsweise etwa 300 bis 50'000, vorzugsweise 400 bis 10'000 Dalton.

Vorzugsweise entspricht die Siloxanverbindung der allgemeinen Formel (I): 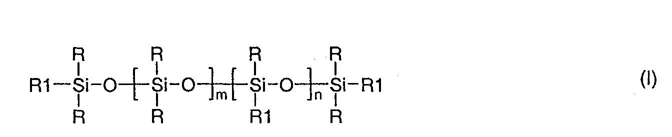 Worin
- R: unabhängig voneinander einen gegebenenfalls fluorierten und/oder chlorierten Alkylrest mit 1-4 C-Atomen, oder Phenyl, vorzugsweise Methyl, Ethyl, Propyl, 3,3,3-Trifluoropropyl, Monofluoropropyl, Difluoromethyl oder Phenyl, vorzugsweise Methyl oder einen Rest der Formel 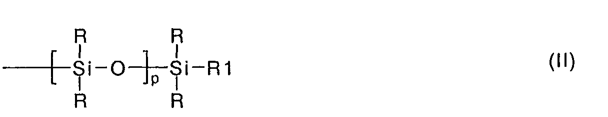
- R₁: unabhängig von einander eine der Bedeutungen von R oder einen reaktiven Rest, oder einen Rest R₂, oder zwei endständige R₁ zusammen die direkte Bindung (entsprechend einer cyclischen Verbindung),
- R₂: ein zweiwertiger Rest, welcher endständig jeweils an ein Si-Atom gebunden ist und durch Reaktion zweier unterschiedlicher reaktiver Reste R₁ entstanden ist,
- m: Null oder eine ganze Zahl von 1-1000, vorzugsweise eine ganze Zahl von 2 bis 500, und vorzugsweise etwa 5 bis 100, insbesondere 5-40;
- n: Null oder eine ganze Zahl von 1-50, vorzugsweise 1-20,
- p: Null oder eine ganze Zahl von 1-50, vorzugsweise Null oder 1-20,
bedeuten, wobei (i) die Summe [m+n+p] im Bereich von 1-1000, vorzugsweise im Bereich von 2-500, vorzugsweise 5-100, und insbesondere bei 5-40, liegt und (ii) die Gruppen [-Si(R)(R)O-] und [-Si(R)(R₁)O-] im Molekül in beliebiger Reihenfolge angeordnet sind.

Bevorzugt stellt die Verbindung der Formel (I) eine lineare oder verzweigte Polydimethylsiloxanverbindung mit endständigen Trimethylsilylgruppen oder ein Gemisch solcher Verbindungen dar, vorzugsweise enthaltend oligomere Polysiloxanverbindungen, vorzugsweise enthaltend ein cyclisches Dimethylsiloxan oder ein Gemisch cyclischer Polydimethylsiloxane. Um die erfindungsgemässe Wirkung zu erzielen, ist es nicht zwingend, dass die Siloxanverbindung reaktive Gruppen aufweist.

Im Rahmen der vorliegenden Erfindung kann das Organopolysiloxan auch reaktive Substituenten R₁ aufweisen, was die erfindungsgemässe Wirkung noch verbessert. Solche reaktive Substituenten, bzw. Gruppen, sind beispielsweise Hydroxyl, oder (C₁-C₄)Alkyl-Epoxid oder Vinyl (≡Si-CH=CH₂) oder Allyl (≡Si-CH₂CH=CH₂) oder Wasserstoff in Form einer Hydrosilylbindung (≡SiH).

In diesem Sinne bedeuten die einzelnen Substituenten R₁ unabhängig voneinander als reaktive Reste vorzugsweise Hydroxyl, oder C₂-Alkyl-Epoxid (Glycidyl) oder Vinyl oder Allyl oder Wasserstoff in Form einer Hydrosilylbindung.

Wählt man für die Beschichtung eine Mischung als Zweikomponentensystem, worin die eine Komponente Hydroxylgruppen und die andere Komponente Epoxidgruppen, z.B. Glycidylgruppen, aufweist, so dass die beiden Komponenten miteinander reagieren, so ergibt sich ein Polysiloxan mit erhöhtem Molekulargewicht, entsprechend der oben angegebenen Verbindung der allgemeinen Formel (I), worin R₂ die aus der Reaktion der Hydroxylgruppe mit der Epoxidgruppe gebildete Brücke der Formel [-C(OH)-CH₂-O-] bedeutet.

Wählt man für die Beschichtung eine Mischung als Zweikomponentensystem, worin die eine Komponente Vinylgruppen oder Allylgruppen und die andere Komponente Hydrosilylgruppen aufweist, so dass die beiden Komponenten unter Zugabe eines geeigneten Katalysators, wie beispielsweise eines an sich bekannten Platinkatalysators, miteinander reagieren, so ergibt sich ein Polysiloxan mit erhöhtem Molekulargewicht, entsprechend der oben angegebenen Verbindung der allgemeinen Formel (I), worin R₂ die aus der Reaktion der Vinylgruppen oder Allylgruppen einerseits und der Hydrosilylgruppen andererseits gebildete Brücke (-CH₂-CH₂- resp. -CH₂-CH₂-CH₂-) bedeutet.

Ist die Verbindung der Formel (I) eine cyclische Verbindung, so ist diese aus -[Si(R)(R)O]- und/oder -[Si(R)(R₁)O]-Einheiten, zusammengesetzt, welche einen Ring mit vorzugsweise 4 bis 12 solcher Einheiten bilden. Von den ringförmigen Siloxanen sind jedoch die ringförmigen Polysiloxane mit 4 bis 8 Siloxy-Einheiten bevorzugt, insbesondere mit vier bis acht -[Si(R) (R)O]-Einheiten, insbesondere 4, 5 oder 6 solcher Einheiten, wobei für die Bedeutungen der Substituenten R und R₁ die vorgehend angegebenen bevorzugten Bedeutungen gelten. Von den cyclischen Verbindungen sind die Polydimethylsiloxane bevorzugt.

Die Herstellung der Verbindungen der Formel (I) ist an sich bekannt oder die Verbindungen können gemäss bekannten analogen Verfahren hergestellt werden. Die Verbindung der Formel (I) stellt in der Regel ein Gemisch von Verbindungen der Formel (I) dar, was dem Fachmann bekannt ist. Vorzugsweise enthält das Gemisch lineare und verzweigte sowie auch cyclische Verbindungen. Vorzugsweise weist das Gemisch jeweils einen Gehalt von bis zu 10 Gew.-%, vorzugsweise etwa 5-8 Gew.-% an cyclischen Verbindungen auf, welche nur aus -[Si(R) (R)O]-Einheiten, bestehen, wie cyclische Dimethylsiloxane mit 4-12 Dimethylsiloxyeinheiten, vorzugsweise solche mit 4, 5 oder 6 Dimethylsiloxyeinheiten.

Für die Herstellung des erfindungsgemässen Füllstoffs geht man vorzugsweise so vor, dass man die Organopolysiloxanverbindung in einem geeigneten Lösungsmittel wie Benzol oder Xylol löst, den porösen nicht beschichteten Füllstoff hinzu fügt, die Mischung unter Rühren, gegebenenfalls bei erhöhter Temperatur z.B. im Bereich von 100°C - 140°C, während z.B. 30 Minuten bis 3 Stunden oder am Rückfluss oder im Vakuum, erwärmt, um die in den Poren vorhandene Luft zu entfernen. Anschliessend wird der Füllstoff isoliert, z.B. filtriert, und getrocknet. Im Trocknungsprozess, welcher gleichzeitig als Härtungsprozess ausgebildet werden kann, wird verbliebenes Lösungsmittel entfernt. Das erhaltene Produkt kann vor der Verwendung gemahlen werden.

Enthält die Organopolysiloxanverbindung reaktive Gruppen, so geht man so vor, dass man jeweils zwei Komponenten, d.h. zwei unterschiedliche Polysiloxane, mischt, nämlich entsprechen der für den Substituenten R₁ genannten Bedeutungen, das heisst, die eine Komponente mit Hydroxylgruppen und die andere Komponente mit Epoxidgruppen, z.B. mit Glycidylgruppen, so dass die beiden Komponenten miteinander reagieren können, wie dies vorgehend für die Bedeutung von R₂ beschrieben ist. Dabei kann auch ohne Lösungsmittel gearbeitet werden wenn die Viskosität der Komponenten genügend niedrig ist.

Entsprechend kann man jeweils zwei Komponenten mit anderen reaktiven Gruppen mischen, nämlich die eine Komponente mit Vinylgruppen oder Allylgruppen und die andere Komponente mit Hydrosilylgruppen, so dass die beiden Komponenten unter Zugabe eines geeigneten Katalysators, wie beispielsweise eines an sich bekannten Platinkatalysators, miteinander reagieren, wie dies vorgehend beschrieben ist, wobei sich die Brücken R₂ bilden.

Enthält die Mischung die beiden Komponenten in äquimolaren Mengen, so verbleiben in der Beschichtung keine reaktiven Gruppen. Enthält die Mischung die eine Komponente im Überschuss, so enthält die Beschichtung die reaktive Gruppe der im Überschuss zugefügten Komponente resp. die entsprechende reaktive Gruppe erscheint in der Verbindung der allgemeinen Formel (I).

In diesem Sinne betrifft die vorliegende Erfindung ein Verfahren zur Herstellung des erfindungsgemässen Füllstoffs, welches dadurch gekennzeichnet ist, dass man eine Mischung enthaltend: (i) ein lineares, zweidimensionales, dreidimensionales und/oder cyclisches Organopolysiloxan oder einem Gemisch solcher Organopolysiloxan gegebenenfalls gelöst in einem geeigneten Lösungsmittel sowie (ii) einen porösen nicht beschichteten Füllstoff bestehend aus porösen anorganischen Pulverteilchen, unter Rühren, gegebenenfalls am Rückfluss und/oder im Vakuum, erwärmt, um die in den Poren vorhandene Luft zu entfernen und die Porenoberfläche möglichst vollständig zu belegen, und gegebenenfalls anschliessend das Lösungsmittel entfernt.

Als Vergussmassen bzw. Giessharzsysteme in flüssiger oder pastöser Form kommen vorzugsweise duroplastisch härtbare Vergussmassen zur Anwendung. Vergussmassen auf Basis duroplastisch härtbarer Harze sind z.B. duroplastisch härtbare Polyaddukte, wie Epoxidharze oder Polyurethane und z.B. duroplastisch härtbare Polykondensate, wie Phenol/Formaldehyd-Kunststoffe, Harnstoff/Formaldehyd-Kunststoffe oder ungesättigte Polyesterharze. Diese besitzen, wie bereits eingehend erwähnt, keine intrinsische Hydrophobiewiederkehr.

Epoxidharzsysteme bestehen in der Regel aus dem Epoxidharz, dem Härter und gegebenenfalls dem Beschleuniger sowie weiteren Zusatzstoffen. Bevorzugt sind Epoxidharze mit guten elektrischen Eigenschaften, vorzugsweise auf der Basis von aromatische und/oder cycloaliphatischen Epoxidharzen. Solche in der Elektroindustrie verwendete Epoxidharze sind an sich aus der Literatur bekannt und können erfindungsgemäss verwendet werden. Zahlreiche Publikationen existieren auch zu den elektrischen Araldit®-Giessharzsystemen der Ciba SC AG.

Als Epoxidharz sind vernetzend wirkende Glycidylverbindungen, welche mindestens zwei 1,2-Epoxidgruppen im Molekül aufweisen, bevorzugt. Vorzugsweise verwendet man ein Gemisch von Polyglycidylverbindungen, beispielsweise ein Gemisch von Diglycidyl- und Triglycidylverbindungen. Solche Verbindungen sind an sich bekannt und in der Literatur ausführlich beschrieben. In der Regel kann aus den bekannten Glycidylverbindungen eine für die vorgesehene elektrische Anwendung geeignete Auswahl getroffen werden, was für den Fachmann ein Optimierungsproblem darstellt.

Geeignete Glycidylverbindungen sind beispielsweise in EP-A-0 297 030, EP-A-0 356 391, EP-A-0 462 053, EP-A-0 506 617, EP-A-0 536 085, EP-A-0 673 957 oder in U.S. Patent US-A-3,859,314 oder in der DE-A-31 26 411 beschrieben. Diese umfassen Verbindungen, die unsubstituierte Glycidylgruppen und/oder mit Methylgruppen substituierte Glycidylgruppen aufweisen. Die Glycidylverbindungen haben vorzugsweise ein Molekulargewicht zwischen 200 und 1200, insbesondere zwischen 200 und 1000 und können fest oder flüssig sein. Ihr Epoxidgehalt beträgt vorzugsweise mindestens drei Äquivalente pro Kilogramm der Verbindung, vorzugsweise mindestens vier Äquivalente pro Kilogramm und insbesondere mindestens fünf Äquivalente pro Kilogramm. Bevorzugt sind Glycidylverbindungen, die Glycidylether- und/oder Glycidylestergruppen aufweisen. Eine Glycidylverbindung kann dabei auch beide Arten von Glycidylgruppen enthalten, wie z.B. 4-Glycidyloxy-benzoesäureglycidylester. Bevorzugt sind Polyglycidylester mit 1-4 Glycidylestergruppen, insbesondere Diglycidylester und/oder Triglycidylester. Die bevorzugten Diglycidylester leiten sich vorzugsweise von aromatischen, araliphatischen, cycloaliphatischen, heterocyclischen, heterocyclisch-aliphatischen oder heterocyclisch-aromatischen Dicarbonsäuren mit 6 bis 20, insbesondere 6 bis 12 Ringkohlenstoffatomen oder von aliphatischen Dicarbonsäuren mit 2 bis 10 Kohlenstoffatomen ab. Solche Verbindung sind beispielsweise unter dem Handelsnamen Araldit® (Ciba SC AG) kommerziell erhältlich. Bevorzugt sind beispielsweise die an sich bekannten Epoxidharze auf Basis mehrwertiger aromatischer oder cycloaliphatischer Hydroxylverbindungen.

Insbesondere geeignet sind gegebenenfalls substituierte Epoxidharze der Formel (VIa): 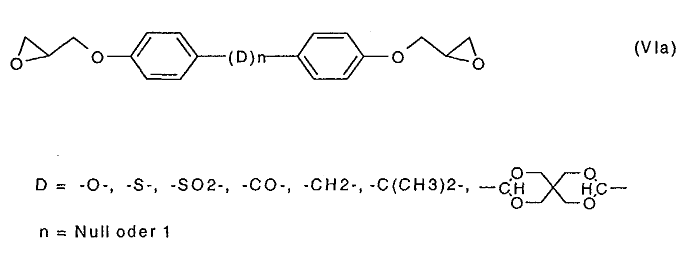 auf der Basis von aromatischen Hydroxylverbindungen. Beispiele sind Glycidylether von Bisphenol A oder Bisphenol F sowie die Glycidylether von Phenol-Novolak-Harzen oder Kresol-Novolak-Harzen.

Cycloaliphatische Epoxidharze sind z.B. Hexahydro-o-phthalsäure-bis-glycidylester, Hexahydro-m-phthalsäure-bis-glycidylester oder Hexahydro-p-phthalsäure-bis-glycidylester. Auch aliphatische Epoxidharze, wie z.B. 1,4-Butandioldiglycidylether, sind für die erfindungsgemässe Verwendung geeignet.

Bevorzugte Epoxidharze mit guten elektrischen Eigenschaften sind auch aromatische und/oder cycloaliphatische Epoxidharze, welche mindestens eine Aminoglycidylgruppe im Molekül enthalten. Solche in der Elektroindustrie verwendeten Epoxidharze sind an sich aus der Literatur bekannt und beispielsweise in WO 99/67315 beschrieben.

Bevorzugt sind Verbindungen der allgemeinen Formel (VIb):

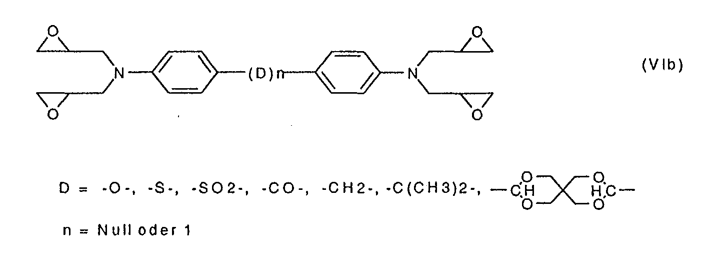

Besonders geeignete Aminoglycidylverbindungen sind N,N-Diglycidylanilin, N,N-Diglycidyltoluidin, N,N,N',N'-Tetraglycidyl-1,3-diaminobenzol, N,N,N',N'-Tetraglycidyl-1,4-diaminobenzol, N,N,N',N'-Tetraglycidylxylylendiamin, N,N,N',N'-Tetraglycidyl-4,4'-diaminodiphenylmethan, N,N,N',N'-Tetraglycidyl-3,3'diethyl-4,4'-diaminodiphenylmethan, N,N,N',N'-Tetraglycidyl-3,3'-diaminodiphenylsulfon, N,N'-Dimethyl-N,N'-diglycidyl-4,4'-diaminodiphenylmethan, N,N,N',N'-Tetraglycidyl-alfa,alfa'-bis(4-aminophenyl)-p-diisopropylbenzol und N,N,N',N'-Tetraglycidyl-alfa,alfa'-bis-(3,5-dimethyl-4-aminophenyl)-p-diisopropylbenzol.

Bevorzugte Aminoglycidylverbindungen entsprechen auch der Formel (VIc): 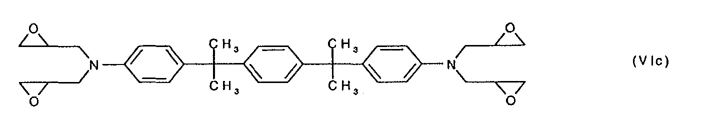 oder der Formel (VId):

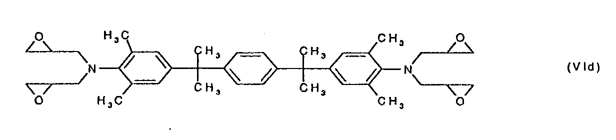

Geeignete Polyglycidylverbindungen von Aminophenolen sind auch O,N,N-Triglycidyl-4-aminophenol, O,N,N-Triglycidyl-3-aminophenol und 2,2-(N,N-Diglycidyl-4-aminopheny-1,4'-glycidyloxyphenyl)-propan. Weitere Aminoglycidylverbindungen, die erfindungsgemäss eingesetzt werden können, sind beschrieben in Houben-Weyl, Methoden der Organischen Chemie, Band E20, Makromolekulare Stoffe, Georg Thieme Verlag Stuttgart, 1987, Seiten 1926-1928. Die tri- und tetrafunktionellen Aminoglycidylverbindungen können beispielsweise nach den in den US. 2 884 406, US 2 921 037 und US 2 951 822 sowie nach den in der EP 0 148 117 beschriebenen Verfahren hergestellt werden.

Als Härter verwendet man an sich bekannte hydroxylhaltige Verbindungen und/oder carboxylhaltige Polymere, insbesondere carboxylterminierte Polyester und/oder carboxylhaltige Acrylat- und/oder Methacrylatpolymere und/oder Carbonsäureanhydride. Solche Härter sind an sich bekannt. Geeignete Härter sind auch cyclische Anhydride von aromatischen, aliphatischen, cycloaliphatischen und heterocyclischen Polycarbonsäuren. Besonders geeignete Anhydride von aromatischen Polycarbonsäuren sind Phthalsäureanhydrid und deren substituierte Derivate, Benzol-1,2,4,5-tetracarbonsäuredianhydrid (Pyromellithsäuredianhydrid) und deren substituierte Derivate, sowie Verbindungen der Formel (VII):

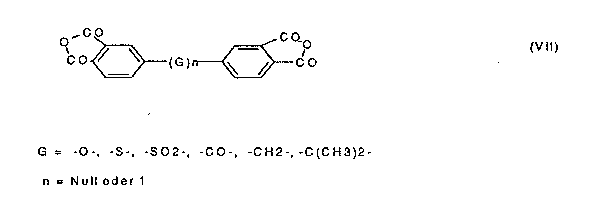

Als Härter geeignete Anhydride sind beispielsweise Phthalsäureanhydrid, 4-Methylphthalsäureanhydrid, 3,6-Dichlorphthalsäureanhydrid, 4,5-Dichlorphthalsäureanhydrid, 3,6-Difluorphthalsäureanhydrid, Tetrabrom-, Tetrachlor- und Tetrafluorphthalsäureanhydrid, 3-Nitro- und 4-Nitro-phthalsäureanhydrid, Benzol-1,2,4,5-tetracarbonsäuredianhydrid (Pyromellithsäuredianhydrid), 3,3',4,4'-Benzophenontetracarbonsäuredianhydrid, 2,2-Bis(3,4-benzoldicarboxyphenyl)propan-dianhydrid, 2,2-Bis(2,3-benzoldicarboxyphenyl)-propandianhydrid, 2,2-Bis(4,4-benzoldicarbonsäureanhydrid)perfluorpropan, Bis(3,4-dicarboxyphenyl)etherdianhydrid, Bis-(3,4-dicarboxylphenyl)methandianhydrid, 2,2',3,3-Diphenyltetracarbonsäuredianhydrid und 3,3',4,4'-Diphenyltetracarbonsäuredianhydrid. Die aromatischen Carbonsäureanhydride können zusätzliche funktionelle Gruppen enthalten. Beispiele sind Benzol-1,2,4-tricarbonsäure-anhydrid (Trimellithsäureanhydrid), 3-Hydroxyphthalsäureanhydrid, 3- bzw. 4-Maleinimidophthalsäureanhydrid sowie das 2-Sulfobenzoesäure-cyclo-anhydrid. Geeignet sind auch Derivate des Trimellithsäureanhydrids wie z.B. das Bistrimellithsäureanhydrid des Neopentylglykols.

Ebenso sind aromatische Carbonsäureanhydride mit kondensierten Ringsystemen geeignet, wie z.B. 1,8-Naphthalsäureanhydrid, Naphthalin-1,4,5,8-tetracarbonsäuredianhydrid, Naphthalin-1,2,5,6-tetracarbonsäuredianhydrid, Naphthalin-3,4,5,8-tetracarbonsäuredianhydrid, Naphthalin-2,3,6,7-tetracarbonsäuredianhydrid, 3,4,9,10-Perylentetracarbonsäuredianhydrid und ihre Halogen und Nitroderivate.

Besonders bevorzugt ist Maleinsäureanhydrid und Derivate von Maleinsäureanhydrid. Diese sind als alleiniges Härtungsmittel für Aminoglycidylharze und für ihre Mischungen mit anderen Epoxidharzen verwendbar.

An sich bekannte Cycloaliphatische Dicarbonsäureanhydride, wie z.B. cis-Cyclohexan-1,2-dicarbonsäureanhydrid und verwandte Verbindungen, bicyclische Verbindungen, wie bicyclische cycloaliphatische Dicarbonsäureanhydride, heterocyclische Carbonsäureanhydride, können ebenso verwendet werden.

Das Härtungsmittel verwendete man in an sich bekannten Konzentrationen im Bereich von 0,4 bis 1,2, vorzugsweise 0.8 bis 1.2, Äquivalente der reaktiven Härtergruppe, z.B. Anhydridgruppe, per 1 Epoxidäquivalent eingesetzt.

Die erfindungsgemässen härtbaren Mischungen können Zusatzstoffe, wie an sich bekannte Füllstoffe, Plastifizierungsmittel, Elastifizierungsmittel, Zähigkeitsvermittler, Antioxidantien, Lichtschutzmittel, Weichmacher, Thixotropiemittel, Entschäumer, Antistatika, Gleitmittel und Entformungshilfsmittel, Flammschutzmittel, Farbstoffe und/oder Verstärkungsfasern enthalten.

An sich bekannte Füllstoffe werden in an sich bekannten Mengen zugesetzt und sind beispielsweise, Holzmehl, Glaspulver, Halbmetall- und Metalloxide, wie zum Beispiel Siliziumdioxid (Aerosile, Quarz, Quarzmehl, Quarzgutmehl), Aluminiumoxid, Titanoxid, Metallhydroxide, [Mg(OH)₂, Al(OH)₃, AlO(OH)], Halbmetall- und Metallnitride, wie Siliziumnitrid, Bornitrid und Aluminiumnitrid, Halbmetall- und Metallcarbide, wie Siliziumcarbid (SiC), Metallcarbonate (Dolomit, Kreide, CaCO₃), Metallsulfate (Baryt, Gips), Gesteinsmehle und natürliche oder synthetische Mineralien hauptsächlich aus der Silikatreihe, wie zum Beispiel Zeolithe (insbesondere Molekularsiebe) Talkum, Glimmer, Kaolin, Wollastonit, Bentonit, Dolomit.

Geeignete Zähigkeitsvermittler sind beispielsweise an sich bekannte Core/Shell-Polymere oder als "Rubber Toughener" bezeichnete Elastomere oder Elastomere enthaltende Pfropfpolymere oder auch vernetzte Silikonpolymere.

Härtungsbeschleuniger sind beispielsweise tertiäre Amine, wie Benzyldimethylamin oder Amin-Komplexe, insbesondere Komplexe von tertiären Aminen, mit Bortrichlorid oder Bortrifluorid; Harnstoffderivate, wie z.B. N-4-Chlorphenyl-N',N'-dimethylharnstoff (Monuron); gegebenenfalls substituierte Imidazole, wie Imidazol oder 2-Phenylimidazol. Bevorzugt sind tertiäre Amine.

Für die Herstellung der erfindungsgemässen Vergussmasse kann man das Epoxidharz, den Härter, den erfindungsgemässen beschichteten Füllstoff, sowie gegebenenfalls anwesende Additive, wie Beschleuniger, an sich bekannte Füllstoffe und weitere Zusatzstoffe, in beliebiger Reihenfolge mischen. Weist die zur Beschichtung des porösen Füllstoffs verwendete Siloxanverbindung eine reaktive Gruppe auf, wie eine Hydroxylgruppe oder eine Epoxidgruppe, so mischt man den erfindungsgemässen Füllstoff vorzugsweise zumindest teilweise zuerst mit dem Epoxidharz oder dem Härter, das heisst, falls die Beschichtung eine Epoxidgruppe aufweist vorzugsweise zuerst mit dem Härter, und falls die Beschichtung eine Hydroxylgruppe aufweist zuerst mit dem Epoxidharz. Anschliessend stellt man mit dieser Vormischung die Vergussmasse her. Die Vormischung wirkt sich positiv auf die Verteilung des erfindungsgemässen Füllmaterials in der Vergussmasse und somit auch auf die elektrischen, physikalischen und mechanischen Eigenschaften des gehärteten Produktes aus.

Die Härtung der erfindungsgemässen Vergussmasse erfolgt bei an sich bekannten Temperaturen, vorzugsweise im Bereich von 50°C bis 180°C, vorzugsweise bei 80°C bis 120°C. Die Härtung der erfindungsgemässen Vergussmasse ist aber in der Regel auch bei niedrigeren Temperaturen möglich, z.B. bei Raumtemperatur, wobei bei einer Aushärtung bei Raumtemperatur ein Zeitraum von wenigen Tagen bis zu wenigen Wochen nötig ist, um eine vollständige Aushärtung zu erreichen.

Die erfindungsgemässen Füllstoffe können analogerweise, wie dies vorgehend für die härtbaren Kunststoffe beschrieben ist, in thermoplastischen Kunststoffen verwendet werden. Dies ist für den Fachmann problemlos. Thermoplastische Kunststoffe sind an sich bekannt, wie beispielsweise Polyolefine, Vinylpolymere, Styrolpolymere, Polyacrylnitrile, Polymethylmethacrylate, Polyamide, Copolymere und verwandte Verbindungen.

Die erfindungsgemässen Vergussmassen werden insbesondere für die Herstellung von Hochspannungsisolierung für den Freilufteinsatz verwendet, insbesondere für die Herstellung von Freiluftisolatoren bei Hochspannungsleitungen als Langstab-, Verbund- und Kappenisolatoren sowie für Stützisolatoren im Mittelspannungsbereich. Die erfindungsgemässen Vergussmassen können auch in der Herstellung Isolierungen bei Freiluft-Leistungsschaltern, Messwandlern, Durchführungen und Ableitern, im Schaltanlagenbau, in Leistungsschaltern, Trockentransformatoren und elektrischen Maschinen, Verwendung finden. Im weiteren können die erfindungsgemässen Vergussmassen auch als Beschichtungsmaterialien für Transistoren und andere Halbleiterelemente und ganz allgemein zum Imprägnieren von elektrischen Bauteilen verwendet werden. Ebenso kann die erfindungsgemässe Vergussmasse als Klebstoff, als Matrixharz für faserverstärkte Kunststoffe, als Korrosionsschutz für metallische Bauteile, z.B. für Brücken und Industrieanlagen, verwendet werden, wobei beispielsweise der Glanz der Schicht auch mit der Alterung nicht verloren geht sowie allgemein zur Herstellung von witterungsbeständigen und wasserabweisenden Polymerprodukten.

Die erfindungsgemässen Füllstoffe können auch in andern duroplastisch härtbaren Kunststoffen sowie in weiteren thermoplastischen Kunststoffen eingesetzt werden, wobei der Fachmann allfällige Unterschiede zu den beschriebenen Epoxidharzen ohne weiteres angleichen kann. Weitere duroplastisch härtbaren Kunststoffe sind beispielsweise duroplastisch härtbare Polyaddukte, wie Polyurethane (PUR) in Form von Vergussmassen bzw. Giessharzsystemen in flüssiger oder pastöser Form, insbesondere Polyurethan-Giessharze auf der Basis von Isoxyanat-Reaktionsharzen und Polyolen.

Weitere geeignete duroplastisch härtbare Kunststoffe sind duroplastisch härtbare Polykondensate, wie Phenol/Formaldehyd-Kunststoffe, Harnstoff/Formaldehyd-Kunststoffe oder ungesättigte Polyesterharze. Diese sind an sich bekannt und besitzen, wie bereits eingehend erwähnt, keine intrinsische Hydrophobiewiederkehr.

Die folgenden Beispiele erläutern die Erfindung.

### Testmethoden

Von den im weiteren beschriebenen Prüflingen wurden die Hydrophobie und die Hydrophobiewiederkehr sowie der Hydrophobicity Transfer Effect (HTE) auf einer verunreinigten Oberfläche gemessen.

Für die Prüfung der Hydrophobiewiederkehr werden die Prüfkörper zur Prüfung der Hydrophobie bzw. der Hydrohobiewiederkehr einer elektrischen Corona-Entladung während einer Zeitdauer von mindestens 20 Minuten, vorzugsweise etwa 60 Minuten, ausgesetzt. Dabei wird vorübergehend die Oberflächenhydrophobie vermindert oder gänzlich zerstört, worauf anschliessend eine Hydrophobie-Erholung einsetzt. Die Hydrophobie wird in an sich bekannter Weise mit dem Dynamischen Vorrückwinkel mit Wasser in Graden gemessen. Je grösser der Vorrückwinkel, um so höher ist die Hydrophobie.

Für die Prüfung des Hydrophobicity Transfer Effects (HTE) (Hydrophobie-Transfer) werden die zu testenden Probeplatten in einem Ultraschallbad in Isopropanol während fünf Minuten gereinigt und anschliessend mit Isopropanol gewaschen und getrocknet. Anschliessend wird auf die Probeplatten eine 0.5 mm dicke Fremdschicht aus nicht silanisiertem Quarzmehl aufgetragen (W12). Dazu kann eine entsprechende Rundlochschablone mit einem Durchmesser von 3 cm verwendet werden. Mit einem Lineal wird das eingefüllte überschüssige Quarzmehl abgestrichen und dafür gesorgt, dass eine glatte Oberfläche erhalten wird. Die präparierten Proben werden bis zur Prüfung in gut verschlossenen und silikonfreien Behältern aufbewahrt. Zur Überprüfung des Hydrophobie Transfers werden dann in geeigneten Zeitabständen aus einer Pipette vorsichtig Wassertropfen auf die Fremdschichten aufgesetzt. Das beobachtete Verhalten der Tropfen wird mit demjenigen in Tabelle 1 verglichen. Dadurch können die Transfer Eigenschaften des untersuchten Materials konkreten Levels von 1-5 zugeordnet werden.

Diese Methode ist in H. Janssen, "Ursache und Lebensdauer der Hydrophobie polymerer Werkstoffe für Hochspannungs-Freiluftisolatoren", Shaker Verlag, Aachen, 2001, beschrieben.

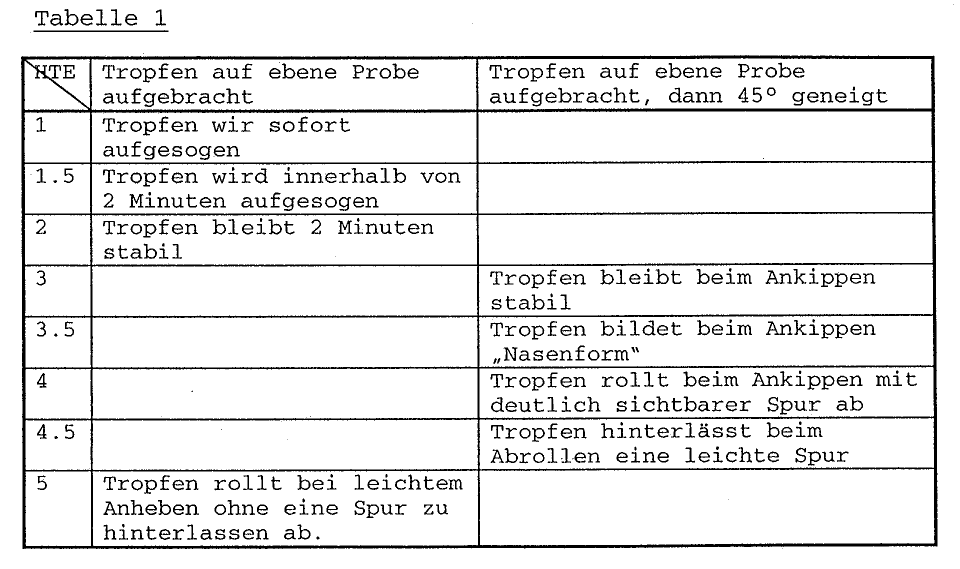

### Beispiel 1

In einem Rundkolben, ausgerüstet mit Rührer und Heizung, werden je 9.8 Teile (zusammen 19.8 Teile) der beiden Komponenten des niederviskosen (500 mPa.s) reaktiven Silikonharzes Sylgard® 527 der Firma Dow Corning, welches ein flüssiges härtbares Zweikomponentensystem darstellt, mit 1.03 Teilen Decamethylcyclopentasiloxan (von GE-Bayer Silicones, Deutschland) bei Raumtemperatur intensiv vermischt. Anschliessend werden 11.18 Teile Xonolit [Ca₂Si₆O₁₇(OH)₂] dazu gegeben und zu einem homogenen Gefüge vermischt. Die Mischung wird dann solange bei 50 mbar evakuiert bis alle Luftblasen entwichen sind, anschliessend wird auf 100°C erwärmt und während 60 Minuten bei dieser Temperatur gehalten und abkühlen gelassen. Zum Schluss wird das erhaltene Produkt gesiebt, um allfällige Agglomerate abzutrennen.

### Beispiel 2

Der in Beispiel 1 erhaltene Füllstoff wurde in die Epoxid-Vergussmasse wie folgt eingearbeitet und ausgehärtet. Zunächst wurde das Epoxidharz mit dem Härter und dem Beschleuniger während 10 Minuten bei 60°C gemischt. Dann wurde der gemäss Beispiel 1 hergestellte erfindungsgemässe Füllstoff in Portionen zugegeben und während weiteren 15 Minuten bis zur gleichmässigen Verteilung intensiv gerührt. Die erhaltene Mischung wurde während zehn Minuten in einem Vakuum mit einem Restdruck im Bereich von 10-20 mbar zur gänzlichen Entfernung aller Blasen ausgesetzt. Nun wurde die Giessform auf eine Temperatur von 60°C gebracht und der Werkstoff bei dieser Temperatur zu 4 mm dicken Platten vergossen. Die gefüllte Giessform wurde dann während zehn Minuten einem Vakuum mit einem Restdruck von 20 bis 30 mbar ausgesetzt. Die Gelierung und der Härtungsprozess wurden bei Normaldruck während 6 Stunden bei 80°C und anschliessend während 10 Stunden bei 140°C durchgeführt. Nach dem Aushärten und Abkühlen wurden aus dem Material Testproben geschnitten.

Die Zusammensetzung der Epoxid-Vergussmasse gemäss diesem Beispiel 2 ist wie folgt:
(i) 35.25 Teile des cycloaliphatischen Epoxidharzes CY184 (der Firma Vantico Ltd., Epoxidzahl: 5.9 val/kg, vorwiegend bestehend aus Hexahydro-m-phthalsäure-bis-glycidylester),
(ii) 31.61 Teile Hexahydrophtalsäureanhydrid (cis-Cyclohexan-1,2-dicarbonsäureanhydrid (Anhydridhärter HT 907 der Firma Vantico Ltd.), und
(iii) 0.55 Teile des Härtungsbeschleuniger DY062 (der Firma Vantico Ltd., chem. Formel: Ph-CH₂-N(CH₂CH₃)₂).

Dieser Vergussmasse werden (i) 11.18 Teile und (ii) 22 Teile des in Beispiel 1 hergestellten Füllstoffs zugesetzt und in einem Mischer während 5 Minuten bei 4'000 Umdrehungen pro Minute bis zur gleichmässigen Verteilung gemischt und wie vorgehend beschrieben weiter verarbeitet. Es werden keine weiteren Additive zugesetzt.

### Beispiel 3 (Vergleichsbeispiel)

In einem Vergleichsversuch wurde Beispiel 2 wiederholt, jedoch mit der Massgabe, dass (i) 11.18 Teile und (ii) 22 Teile unbeschichtetes Xonolit [Ca₂Si₆O₁₇(OH)₂] dazu gegeben wurden.

### Beispiel 4 (Vergleichsbeispiel)

In einem Vergleichsversuch wurde Beispiel 2 wiederholt, jedoch mit der Massgabe, dass (i) 11.18 Teile und (ii) 22 Teile unbeschichtetes (Quarzmehl W12 von Quarzwerke Frechen, Deutschland) dazu gegeben wurden.

Von den erhaltenen Prüflingen gemäss den Beispielen 2, 3, 4 und 5 sind die gemessenen Werte für die Hydrophobie und die Hydrophobiewiederkehr in Tabelle 2 aufgelistet.

### Beispiel 5

In einem Vergleichsversuch wurde Beispiel 4 wiederholt, jedoch mit dem Unterschied, dass die in Beispiel 4 verwendete Epoxidkomponente durch die hydrophobisierend wirkende Epoxidkomponente CY 5622 (der Firma Ventico Ltd.) ersetzt wurde. Diese enthält in einer Emulsion Silikonöle und zeigt daher verbesserte hydrophobe Eigenschaften. Der Füllstoffanteil betrug wiederum (i) 11.18 Teile und (ii) 22 Teile unbeschichtetes Quarzmehl (W 12).

**Tabelle 2**

| | Dynamischer Vorrückwinkel (Wasser, in °) Prüfkörper aus Beispiel 2 (ii) | Dynamischer Vorrückwinkel (Wasser, in °) Prüfkörper aus Beispiel 3(ii)* | Dynamischer Vorrückwinkel (Wasser, in °) Prüfkörper aus Beispiel 4 (ii) | Dynamischer Vorrückwinkel (Wasser, in °) Prüfkörper aus Beispiel 5 (ii) |
|---|---|---|---|---|
| Grundhydrophobie (ohne Corona-Entladung | 108 | 106 | 102 | 110 |
| Grundhydrophobie (nach 1. Corona-Entladung) | 29 | 32 | 26 | 24 |
| Hydrophobie nach 50 h (nach 1. Corona-Entladung) | 60 | 47 | 43 | 46 |
| Hydrophobie nach 120 h (nach 1. Corona-Entladung) | 88 | 58 | 62 | 60 |
| Hydrophobie nach 400 h (nach 1. Corona-Entladung) | 97 | 69 | 72 | 68 |
| Grundhydrophobie (nach 2. Corona-Entladung) | 33 | 28 | 22 | 27 |
| Hydrophobie nach 50 h (nach 2. Corona-Entladung) | 48 | 42 | 44 | 41 |
| Hydrophobie nach 120 h (nach 2. Corona-Entladung) | 85 | 55 | 52 | 57 |
| Hydrophobie nach 400 h (nach 2. Corona-Entladung) | 94 | 56 | 52 | 59 |
| Analoge Werte werden für die Systeme aus den Beispielen 2(i), 3(i) und 4(i) erhalten. | | | | |

Von den erhaltenen Prüflingen gemäss den Beispielen 2, 3, 4 und 5 sind die gemessenen Werte für den Hydrophobie Transfer Effect (HTE) in Tabelle 3 aufgelistet.

**Tabelle 3**

| | HTE Prüfkörper aus Beispiel 2(ii) | HTE Prüfkörper aus Beispiel 3(ii)* | HTE Prüfkörper aus Beispiel 4 (ii) | HTE Prüfkörper aus Beispiel 5 (ii) |
|---|---|---|---|---|
| Applikation 1 | | | | |
| 0 h | 1 | 1 | 1 | 1 |
| 50 h | 3 | 1 | 1 | 1 |
| 150 h | 4 | 1 | 1 | 1 |
| 350 h | 4.5 | 1 | 1 | 1 |

| Applikation 2 | | | | |
|---|---|---|---|---|
| 0 h | 1 | 1 | 1 | |
| Hydrophobie nach 50 h | 3 | 1 | 1 | 1 |
| Hydrophobie nach 120 h | 4 | 1 | 1 | 1 |
| Hydrophobie nach 400 h | 4.5 | 1 | 1 | 1 |
| Analoge Werte werden für die Systeme aus den Beispielen 2(i), 3(i) und 4(i) erhalten. | | | | |

## Patentansprüche

**1.** Füllstoff, welcher für die Verwendung in elektrischen Formteilen und elektrischen Beschichtungen auf Basis einer Duroplastmatrix oder einer thermoplastischen Vergussmasse geeignet ist, **dadurch gekennzeichnet, dass** der Füllstoff aus porösen anorganischen Pulverteilchen besteht, deren Porenoberfläche mit einem linearen, zweidimensionalen, dreidimensionalen und/oder cyclischen Organopolysiloxan oder einem Gemisch solcher Organopolysiloxane beschichtet ist.

**2.** Füllstoff nach Anspruch 1, **dadurch gekennzeichnet, dass** dieser aus porösen anorganischen Pulverteilchen, oder mehreren agglomerierten Pulverteilchen, besteht, deren Porenoberfläche mit einem linearen, zweidimensionalen, dreidimensionalen und/oder cyclischen Organopolysiloxan, oder einem Gemisch solcher Organopolysiloxane, beschichtet ist.

**3.** Füllstoff nach Anspruch 1 oder 2, **dadurch gekennzeichnet, dass** die Poren, je nach dem Belegungsgrad der Porenoberfläche, teilweise oder gänzlich durch das Organopolysiloxan verschlossen sind.

**4.** Füllstoff nach einem der Ansprüche 1-3, **dadurch gekennzeichnet, dass** die darin enthaltenen anorganischen porösen Pulverteilchen aus den folgenden Stoffen ausgewählt sind: Siliziumoxid, Aluminiumoxid; Magnesium- und Aluminiumhydroxide; Gesteinsmehle und natürliche oder synthetische Mineralien, vorzugsweise aus der Silikatreihe, vorzugsweise Glimmer, Kaolin, Wollastonit, Bentonit; Calciumsilikate, vorzugsweise Xonolit [Ca₂Si₆O₁₇(OH)₂]; Aluminiumsilikate, vorzugsweise Andalusit [Al₂O₃.SiO₂] oder Zeolithe; Calcium/-Magnesiumcarbonate, vorzugsweise Dolomit [CaMg(CO₃)₂], sowie bekannte Calcium/Magnesiumsilikate, in verschiedenen an sich bekannten Mahlungen.

**5.** Füllstoff nach Anspruch 4, **dadurch gekennzeichnet, dass** die darin enthaltenen anorganischen porösen Pulverteilchen aus den folgenden Stoffen ausgewählt sind: Siliziumoxid und/oder Aluminiumoxid, Xonolit, Magnesium- und Aluminiumhydroxide, Gesteinsmehle und natürliche oder synthetische Mineralien aus der Silikatreihe.

**6.** Füllstoff nach einem der Ansprüche 1-5, **dadurch gekennzeichnet, dass** dieser eine durchschnittliche Korngrösse im Bereich von 1 µm bis 300 µm, vorzugsweise von 5 µm bis 100 µm, aufweist.

**7.** Füllstoff nach einem der Ansprüche 1-6, **dadurch gekennzeichnet, dass** die darin enthaltenen anorganischen Pulverteilchen eine Dichte im Bereich von 60% bis 80% im Vergleich zur realen Dichte der nicht porösen Pulverteilchen aufweisen.

**8.** Füllstoff nach einem der Ansprüche 1-6, **dadurch gekennzeichnet, dass** die darin enthaltenen anorganischen Pulverteilchen eine Gesamtoberfläche von mindestens 20 m²/g (BET m²/g), vorzugsweise 30 m²/g (BET), vorzugsweise im Bereich von 30 m²/g (BET) bis 100 m²/g (BET), und vorzugsweise 40 m²/g (BET) bis 60 m²/g (BET), aufweisen.

**9.** Füllstoff nach einem der Ansprüche 1-6, **dadurch gekennzeichnet, dass** dieser das Organopolysiloxan in einem Volumenanteil von 10-40 Vol.-%, und vorzugsweise in einer Menge von 17-25 Vol.-%, bezogen auf das Gesamtvolumen des beschichteten Füllstoffs enthält.

**10.** Füllstoff nach einem der Ansprüche 1-9, **dadurch gekennzeichnet, dass** mindestens die Porenoberfläche beschichtet ist und die Poren offen oder verschlossen sind.

**11.** Füllstoff nach einem der Ansprüche 1-10, **dadurch gekennzeichnet, dass** dieser das Organopolysiloxan im Gewichtsverhältnis von 50-80 Gew.-%, vorzugsweise von 63-71 Gew.-%, bezogen auf das Gesamtgewicht des Füllstoffs, enthält.

**11.** Füllstoff nach einem der Ansprüche 1-11, **dadurch gekennzeichnet, dass** das für die Beschichtung verwendete Polyorganosiloxan eine Viskosität im Bereich von 0.97 mPa.s bis 19'500 mPa.s (gemessen gemäss DIN 53 019 bei 25°C, berechnet mit einer Dichte von 0.97) aufweist und eine lineare, zweidimensional oder dreidimensional verzweigte Verbindung, ein Gemisch oligomerer Verbindungen oder ein Gemisch solcher Verbindungen darstellt.

**12.** Füllstoff nach Anspruch 11, **dadurch gekennzeichnet, dass** die Viskosität des verwendeten Organopolysiloxans im Bereich von 0.97 mPa.s bis 4900 mPa.s, vorzugsweise im Bereich von 2 mPa.s bis 2900 mPa.s, vorzugsweise im Bereich von 5 bis 700 mPa.s (gemessen gemäss DIN 53 019 bei 25°C) liegt.

**13.** Füllstoff nach einem der Ansprüche 1-12, **dadurch gekennzeichnet, dass** das verwendete Organopolysiloxan ein Molekulargewicht im Bereich von etwa 300 bis 100'000, vorzugsweise etwa 300 bis 50'000, und vorzugsweise 400 bis 10'000 Dalton, aufweist.

**14.** Füllstoff nach einem der Ansprüche 1-13, **dadurch gekennzeichnet, dass** die verwendete Siloxanverbindung der allgemeinen Formel (I): 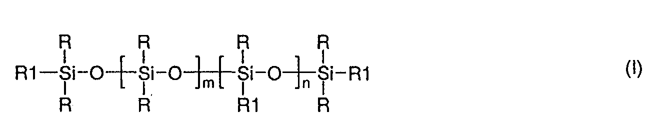 entspricht, worin
R unabhängig voneinander einen gegebenenfalls fluorierten und/oder chlorierten Alkylrest mit 1-4 C-Atomen, oder Phenyl, vorzugsweise Methyl, Ethyl, Propyl, 3,3,3-Trifluoropropyl, Monofluoropropyl, Difluoromethyl oder Phenyl, vorzugsweise Methyl oder einen Rest der Formel 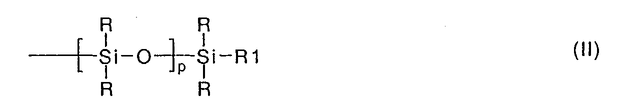
R₁ unabhängig von einander eine der Bedeutungen von R oder einen reaktiven Rest, oder einen Rest R₂, oder zwei endständige R₁ zusammen die direkte Bindung (entsprechend einer cyclischen Verbindung),
R₂ ein zweiwertiger Rest, welcher endständig jeweils an ein Si-Atom gebunden ist und durch Reaktion zweier unterschiedlicher reaktiver Reste R₁ entstanden ist,
m Null oder eine ganze Zahl von 1-1000, vorzugsweise eine ganze Zahl von 2 bis 500, und vorzugsweise etwa 5 bis 100, insbesondere 5-40;
n Null oder eine ganze Zahl von 1-50, vorzugsweise 1-20,
p Null oder eine ganze Zahl von 1-50, vorzugsweise Null oder 1-20,
bedeuten, wobei (i) die Summe [m+n+p] im Bereich von 1-1000, vorzugsweise im Bereich von 2-500, vorzugsweise 5-100, und insbesondere bei 5-40, liegt und (ii) die Gruppen [-Si(R)(R)O-] und [-Si(R)(R₁)O-] im Molekül in beliebiger Reihenfolge angeordnet sind.

**15.** Füllstoff nach Anspruch 14, **dadurch gekennzeichnet, dass** die Verbindung der Formel (I) eine lineare oder verzweigte Polydimethylsiloxanverbindung mit endständigen Trimethylsilylgruppen oder ein Gemisch solcher Verbindungen darstellt, vorzugsweise enthaltend oligomere Polysiloxanverbindungen, vorzugsweise enthaltend ein cyclisches Dimethylsiloxan oder ein Gemisch cyclischer Polydimethylsiloxane.

**16.** Füllstoff nach Anspruch 14 oder 15, **dadurch gekennzeichnet, dass** das Organopolysiloxan der Verbindung der Formel (I) reaktive Substituenten R₁ aufweist, vorzugsweise Hydroxyl, oder (C₁-C₄)Alkyl-Epoxid oder Vinyl (≡Si-CH=CH₂) oder Allyl (≡Si-CH₂CH=CH₂) oder Wasserstoff in Form einer Hydrosilylbindung (≡SiH), vorzugsweise Hydroxyl, oder C₂-Alkyl-Epoxid (Glycidyl) oder Vinyl oder Allyl oder Wasserstoff in Form einer Hydrosilylbindung.

**17.** Füllstoff nach Anspruch 16, **dadurch gekennzeichnet, dass** das Organopolysiloxan der Verbindung der Formel (I) reaktive Substituenten R₁ aufweist und als Zweikomponentensystem vorliegt, worin die eine Komponente Hydroxylgruppen und die andere Komponente Epoxidgruppen, vorzugsweise Glycidylgruppen, aufweist.

**18.** Füllstoff nach Anspruch 16, **dadurch gekennzeichnet, dass** das Organopolysiloxan der Verbindung der Formel (I) reaktive Substituenten R₁ aufweist und als Zweikomponentensystem vorliegt, worin die eine Komponente Vinylgruppen oder Allylgruppen und die andere Komponente Hydrosilylgruppen aufweist, wobei die beiden Komponenten unter Zugabe eines geeigneten Katalysators, vorzugsweise eines an sich bekannten Platinkatalysators, miteinander reagieren.

**19.** Füllstoff nach einem der Ansprüche 1-18, **dadurch gekennzeichnet, dass** das Organopolysiloxan der Verbindung der Formel (I) eine cyclische Verbindung darstellt, welche aus -[Si(R)(R)O]- und/oder -[Si (R) (R₁)O]-Einheiten zusammengesetzt ist, welche einen Ring mit vorzugsweise 4 bis 12 solcher Einheiten, vorzugsweise mit 4 bis 8 Siloxy-Einheiten, insbesondere mit vier bis acht -[Si(R) (R)O]-Einheiten, insbesondere 4, 5 oder 6 solcher Einheiten, gebildet ist und vorzugsweise ein Polydimethylsiloxan darstellt.

**20.** Füllstoff nach einem der Ansprüche 1-19, **dadurch gekennzeichnet, dass** das Organopolysiloxan ein Gemisch von Organopolysiloxanen darstellt, welches lineare und verzweigte sowie auch cyclische Verbindungen enthält, und einen Gehalt von bis zu 10 Gew.-%, vorzugsweise etwa 5-8 Gew.-% an cyclischen Verbindungen aufweist, vorzugsweise cyclische Dimethylsiloxane mit 4-12 Dimethylsiloxyeinheiten, vorzugsweise solche mit 4, 5 oder 6 Dimethylsiloxyeinheiten.

**21.** Verfahren zur Herstellung des Füllstoffs nach einem der Ansprüche 1-20, **dadurch gekennzeichnet, dass** man eine Mischung enthaltend: (i) ein lineares, zweidimensionales, dreidimensionales und/oder cyclisches Organopolysiloxan oder einem Gemisch solcher Organopolysiloxan gegebenenfalls gelöst in einem geeigneten Lösungsmittel sowie (ii) einen porösen nicht beschichteten Füllstoff bestehend aus porösen anorganischen Pulverteilchen, unter Rühren, gegebenenfalls am Rückfluss und/oder im Vakuum, erwärmt, um die in den Poren vorhandene Luft zu entfernen und die Porenoberfläche möglichst vollständig zu belegen, und gegebenenfalls anschliessend das Lösungsmittel entfernt.

**22.** Verwendung des Füllstoffs nach einem der Ansprüche 1-20 in Vergussmassen bzw. Giessharzsystemen in flüssiger oder pastöser Form, vorzugsweise in duroplastisch härtbaren Vergussmassen oder thermoplastischen Vergussmassen.

**23.** Verwendung nach Anspruch 22 in duroplastisch härtbaren Vergussmassen bzw. Giessharzsystemen in flüssiger oder pastöser Form, vorzugsweise in Vergussmassen auf Basis duroplastisch härtbarer Harze, duroplastisch härtbarer Polyaddukte und/oder duroplastisch härtbarer Polykondensate.

**24.** Verwendung nach Anspruch 23 in duroplastisch härtbaren Vergussmassen bzw. Giessharzsystemen in flüssiger oder pastöser Form, vorzugsweise in Epoxidharzen oder Polyurethanen, in Phenol/Formaldehyd-Kunststoffen, in Harnstoff/Formaldehyd-Kunststoffen oder in ungesättigte Polyesterharzen, vorzugsweise in Epoxidharzen.

**25.** Verwendung nach Anspruch 22 in thermoplastischen Kunststoffen, vorzugsweise ausgewählt aus der gruppe der Polyolefine, Vinylpolymere, Styrolpolymere, Polyacrylnitrile, Polymethylmethacrylate, Polyamide, Copolymere und verwandten Verbindungen.

**26.** Die nach einem der Ansprüche 22-25 hergestellten Vergussmassen.

**27.** Vergussmassen nach Anspruch 26 enthaltend einen Füllstoff nach einem der Ansprüche 1-20, **dadurch gekennzeichnet, dass** die Vergussmasse die Polysiloxanverbindung, oder das Gemisch der Polysiloxanverbindungen, in einer Menge von 0.6-30 Gew.-%, vorzugsweise 12-27 Gew.-% und insbesondere in einer Menge von 17-23 Gew.-%, bezogen auf das Gesamtgewicht der Vergussmasse, enthält.

**28.** Verwendung der Vergussmasse nach Anspruch 25 oder 26 für die Herstellung von Hochspannungsisolierung für den Freilufteinsatz, vorzugsweise für Freiluftisolatoren bei Hochspannungsleitungen als Langstab-, Verbund- und Kappenisolatoren sowie für Stützisolatoren im Mittelspannungsbereich, für Isolierungen bei Freiluft-Leistungsschaltern, Messwandlern, Durchführungen und Ableitern, im Schaltanlagenbau, in Leistungsschaltern, Trockentransformatoren und elektrischen Maschinen, als Beschichtungsmaterialien für Transistoren und andere Halbleiterelemente, zum Imprägnieren von elektrischen Bauteilen, als Klebstoff, als Matrixharz für faserverstärkte Kunststoffe, als Korrosionsschutz für metallische Bauteile sowie zur Herstellung von witterungsbeständigen und wasserabweisenden Polymerprodukten.

**29.** Die nach Anspruch 28 hergestellten Bauteile.
